(19) Europäisches Patentamt
European Patent Office
Office européen des brevets

(11) Publication number: **0 328 333 A2**

(12) # EUROPEAN PATENT APPLICATION

(21) Application number: **89301140.3**

(22) Date of filing: **06.02.89**

(51) Int. Cl.4: **H 01 L 39/24**
C 04 B 35/50

(30) Priority: **10.02.88 US 154393**

(43) Date of publication of application:
**16.08.89 Bulletin 89/33**

(84) Designated Contracting States:
**CH DE FR GB IT LI**

(71) Applicant: **WESTINGHOUSE ELECTRIC CORPORATION**
**Westinghouse Building Gateway Center**
**Pittsburgh Pennsylvania 15222 (US)**

(72) Inventor: **Charles, Robert George**
**4873 Christopher Drive**
**Allison Park, PA 15101 (US)**

**Mazelsky, Robert**
**140 Burke Drive**
**Monroeville, PA 15146 (US)**

**Schmidt, Dennis Norbert**
**4806 Lima Way**
**Pittsburgh, PA 15224 (US)**

**Cifone, William Sam**
**14541 Watson Drive**
**Irwin, PA 15642 (US)**

**Szedon, John Robert**
**20 Greenwood Road**
**Pittsburgh, PA 15221 (US)**

(74) Representative: **van Berlyn, Ronald Gilbert**
**23, Centre Heights**
**London, NW3 6JG (GB)**

(54) **Process for producing ceramic superconductors.**

(57) Vapor deposition process for making barium and/or strontium containing ceramic superconductors utilizing vaporization of chelates of the metallic constituents of the superconductor at 150-350C to produce a composite vapor which can be mixed with an oxygen-containing gas for depositing a very homogeneous ceramic film on a heated substrate. This process attempts to solve the barium and/or strontium source material volatility problem which has generally prevented the chemical vapor deposition of such materials.

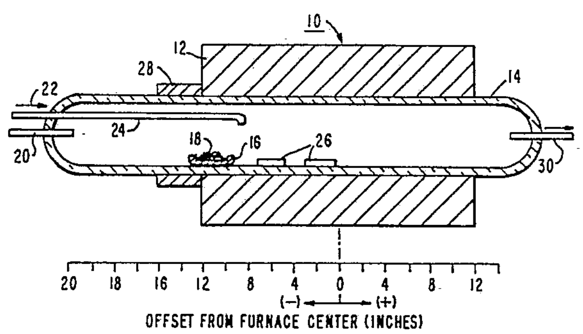

FIG.1A

EP 0 328 333 A2

**Description**

## PROCESS FOR PRODUCING CERAMIC SUPERCONDUCTORS

This invention relates to a process for producing ceramic superconductors continuing barium and/or strontium.

The recent discovery by Muller and Bednorz of ceramic superconductors which are superconductive at relatively high temperatures (e.g. now 90K or above) has dramatically increased the interest in superconductivity and resulted in a large number of publications. The previous metallic superconductors such as niobium-tin or niobium-titanium required expensive liquid helium cooling. The new ceramic superconductors can be cooled by a relatively inexpensive means, such as liquid nitrogen. The ceramic superconductors have generally been oxides of at least one rare earth (hereafter the term "rare earth" will be understood to include yttrium as well as the lanthanide elements, unless otherwise stated), at least one alkaline earth metal, and copper. Typically, the superconductors have been prepared by milling oxides of the rare earth and copper with an alkaline earth metal carbonate (e.g. yttrium oxide, copper oxide, and barium carbonate) and firing the mixture in an oxidizing atmospher at 1000-1100C, (typically regrinding, refiring, etc. a number of times) and then annealing the ceramic in an oxygen atmosphere at 400-900C for an extended period of time (e.g. 0.5-5 days).

Ku et al. in a Paper entitled "Superconductivity and Phase Stability in the Heavy Rare Earth Quaternary Compounds $RBa_2Cu_3O_7$ (R = Ho, Er, Tm, Yb, Lu)" in the Symposium of the MRS spring meeting, 1987, discussed superconductivity in the lanthanum-barium-copper oxide system. Their powders were milled, pressed, sintered, ground, repressed and annealed to prepare samples.

Yoshizaki et al. in a paper entitled "Superconducting Properties of $La_{1.85}$ $Sr_{0.15}$ $CuO_4$ Made by Hot Press and Sintered Methods" investigated superconducting transition properties by resistivity and magnetization in lanthanum-strontium-copper oxide for hot pressed and sintered samples. A single crystal was obtained in a portion of one sample.

Christen et al. in a paper entitled "Correlations Among Thermal Processing, Superconducting Properties and Microstructure in $La_{1.85}Sr_{0.15}CuO_4$" synthesized materials beginning with co-precipitation of lanthanum oxide, strontium oxide, and copper oxide from solution in molten urea followed by cold pressing into pellets, sintering/reacting at 1100C for four hours in air and annealing in flowing oxygen at 900C for 16 hours.

Willis et al. in a letter to the editor entitled "Superconductivity Above 90K in Magnetic Rare Earth-Barium-Copper Oxides" (Journal of Magnetism and Magnetic Materials 67, 1987, North Holland, Amsterdam) report measurements of superconducting and magnetic behavior on samples which were prepared by sintering the rare earth oxide, copper oxide, and barium carbonate in an oxygen atmosphere at 1000C, regrinding and resintering at least twice more to promote reaction and obtain the desired phase.

Shamoto et al. in the Japanese Journal of Applied Physics, April, 1987, article entitled "Effect of Vacuum Annealing on the Superconducting Transition Temperature of La-Sr-Cu-O System" report the effect of vacuum annealing on the superconducting transition temperature of the superconductor lanthanum-strontium-copper oxide system. Their starting materials were apparently oxides pressed and sintered at about 1100C.

Uwe et al. in the May, 1987 Japanese Journal of Applied Physics paper entitled "Affect of Hetero-Valiant Ion Doping in the High $T_C$ Y-Ba-Cu-O Superconductor" discussed the effect of cerium or lanthanum doping on the resistive transition of high $T_C$ superconductors (i.e. yttrium-barium-copper oxide). The samples were subjected to a procedure in which the material was pulverized, pressed and fired at 850-1000C for 2-10 hours in air or oxygen, with the procedure performed two or three times. Some of the samples were then annealed in oxygen at 700C for two or three hours. Their doping did not improve the properties and they saw some degradation.

Kasowski et al. in a paper received March 25, 1987 entitled "Electronic Structure of Pure and Doped Orthorombic $La_2CuO_4$" investigate the electronic structure of orthorombic lanthanum-copper oxide and discuss the implications for superconductivity.

Cooke et al. in a paper entitled "Thermally Stimulated Luminescence from Rare Earth Doped Barium Copper Oxides" discuss luminescence and emission spectrum measurements of rare-earth-doped barium-copper oxides. The loss of luminescence sensitivity with time, especially when the samples were maintained in vacuum, and the propensity of oxygen-defect perovskites to readily lose or gain oxygen were noted. It was suggested that these measurements might present a very sensitive way to investigate the problem of oxygen stability in these materials.

U.S. Patent Specification Nos. 4,411,959 and 4,575,927 (Braginski et al.), issued October 25, 1983 and march 18, 1986, respectively, teach a submicron particle superconductor arrangement in which brittle superconductive particles remain unsintered in the fabricated wire, thus give a ductile wire, even though the superconducting material is brittle. The small particles provide spacing between particles of much less than the Ginzburg-Landau coherence lengths to avoid any significant degradation to $T_c$. U.S. Patent Specification No. 4,419,125 (Charles et al.) teaches using liquid alkali metal to co-reduce a mixture of solid halides to produce such submicron powders.

Accordingly, the present invention resides in a process for procuding ceramic superconductors containing barium and/or strontium characterized by vaporizing chelates of metallic constituents of the superconductor at 150-135C, thereby producing a chelate composite vapor; mixing said chelate composite vapor with

oxygen-containing gas to produce a gaseous chemical vapor deposition mixture; heating a substrate to from 350 to 650C; and contacting said gaseous chemical vapor deposition mixture to said substrate to produce a ceramic film.

Preferably, the substrate is a single crystal perovskite (e.g. strontium titanate) substrate. Preferably the metallic constituents are yttrium, copper and barium and/or strontium. Volatile chelates of these metallic constitutents are vaporized in a stream of inert carrier gas which transports the chelates to a heated substrate, the temperature of which can differ from those necessary to vaporize the chelates. Immediately prior to contacting the heated substrate, the volatilized chelate vapors are mixed with oxygen gas (or an oxygen water-vapor mixture) to effect oxide formation at the hot substrate target.

Preferably, barium is one of the metallic constituents, and Bis [1,1,1,2,2,3,3,-heptafluoro-7,7-dimethyl-4,6-octanedionato] barium(II) is used as the barium chelate, and yttrium is one of the metallic constituents, and Tris [1,1,1,2,2,3,3,-heptafluoro-7,7-dimethyl-4,6-octanedionato] yttrium(III) is used as the yttrium chelate, and copper is one of the metallic constituents, and Bis [acetyl-acetoneimide] copper(II) is used as the copper chelate. When strontium is one of the metallic constituents Bis [1,1,1,2,2,3,3,-heptafluoro-7,7-dimethyl-4,6-octanedionato] strontium(II) is used preferably as the strontium chelate.

There is much current interest in the superconducting oxide materials based on the generic compound $YBa_2Cu_3O_7$ (subsequent references to this compound will be made using the notation "1:2:3"). The 1:2:3 compound in a layered, perovskite-related structure containing oxygen defects undergoes a superconducting transition with $T_c$ between 90 and 100K. Much of the earliest work on 1:2:3 material involved pellets produced by ceramic technology methods or growth of aggregates of very small single crystals.

An entire area of material work addresses the preparation of 1:2:3 films. Such films are important for potential applications in superconducting devices, superconducting interconnections for semiconductor circuits, and for fabricating conducting tapes, etc. To date films have been prepared by sputtering from ceramic 1:2:3 targets or by physical vapor deposition, onto heated (500 to 650C) or unheated substrates in the presence of oxygen, from metallic sources using electron beams or lasers. Additional post-baking in oxygen at temperatures of 400 to 650C may be needed to adjust the oxygen content of the variously produced films and yield superconducting behavior. Prior to the post-baking, films may be heated to 850-950C to provide a tetragonal form and then slow cooled to allow a tetragonal to orthohombic transformation at about 650C. Preferably, however, the orthohombic-pervoskite form is formed during deposition and the transformation avoided.

There are deficiencies with the film preparation methods used to date. Sputtering methods, although successful for producing conducting metallic films or for insulating or dielectric layers, to date have generally not yielded good films in which more complex electronic properties were required. This may be related to the surface bombardment damage associated with sputtering processes. Furthermore, the physical vapor deposition methods are not amenable to large scale applications with good control or uniformity of composition. This is primarily due to the fact that the physical sources are very limited in size compared with the desired product areas. Although large area electron beam sources have been developed for individual metals, the combination of multiple sources for depositions of complex materials has not been achieved.

Chemical vapor deposition (CVD), should overcome the major deficiencies listed above. As an example, CVD with metal-organic (MO) source materials is widely used to prepare high quality films of GaAs and AlGaAs for microwave device and laser applications. In addition, CVD is used in the preparation of films of silicon dioxide and silicon nitride which are used for insulating or masking purposes in both Si and GaAs devices and integrated circuits. CVD equipment for high throughput of large area semiconductor substrates exists and is undergoing continual upgrading.

The primary problem in the case of CVD of 1:2:3 material is finding a source material for barium and/or strontium with adequate volatility. Available materials (such as barium isopropoxide or barium 2,4-pentanedionate) have very low volatility at convenient temperatures. While a bis(cyclopentadienyl) derivative, with a sublimation temperature of 420C might be a more appropriate barium source compound (generally barium will be discussed, but the situation with strontium is analogous) than those already available such high temperatures are undesirable, being more difficult to control than lower temperatures and requiring that the vapor supply lines to the CVD reaction zone be heated to comparable temperatures. A similar, but less critical, situation exists regarding sources for yttrium, and the rare earths analogous compounds for these metals are generally somewhat more volatile than those of barium.

We believe that the use of metal chelate compounds would constitute a better approach for obtaining volatile precursors of all three metals: Ba, Y, and Cu. It has been found that incorporating a multiplicity of bulky organic groups into the organic portion of such chelates tends to increase volatility of the metal chelates, often dramatically. This is due to the relatively large forces of attraction which exist between the adjacent chelate molecules in the solid or liquid form as a result of the ionic character of the metal-ligand bonds. Barium chelates have especially high intermolecular attractions due to the high ionic character of barium-ligand bonds. Intermolecular forces of this type are minimized by the incorporation of the bulky groups mentioned above, since metal-metal distances between adjacent molecules can be greatly increased and intermolecular forces correspondingly decreased. Appropriate bulky substituents which can be incorporated into metal chelates include fluorine and/or methyl groups.

The specific compounds which we have synthesized for CVD studies, based on the above considerations, are shown below:

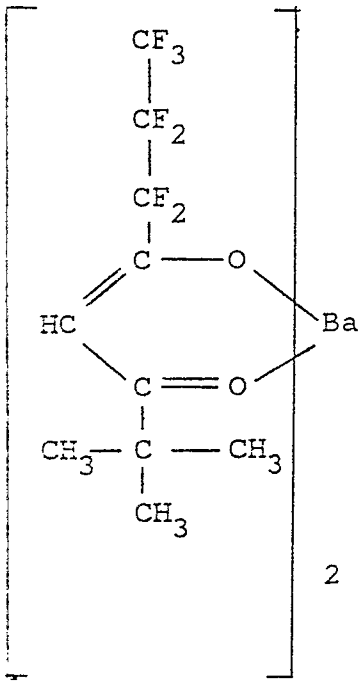

Bis[1,1,1,2,2,3,3,-heptafluoro-7,7-dimethyl-4,6-octanedionato] barium(II)

Abbreviation: Ba(hfod)$_2$

8

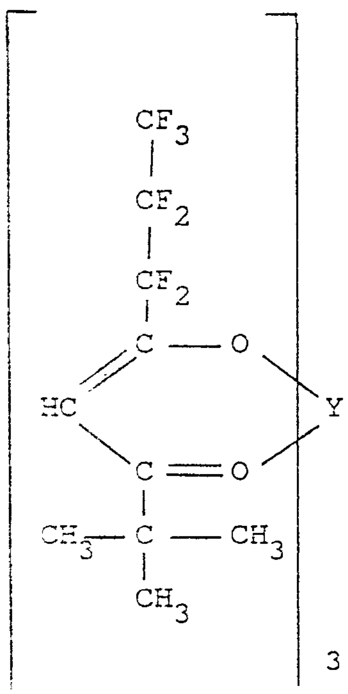

Tris[1,1,1,2,2,3,3,-heptafluoro-7,7-dimethyl-4,6-octanedionato] barium(III)

Abbreviation: Y(hfod)$_3$

While Cu volatile chelates analogous to the above can be synthesized, it is less necessary to have bulky groups incorporated into the organic portion of these molecules due to the lower ionic character of the copper-oxygen bonds. We prefer instead to utilize the more easily prepared chelate Bis [acetyl-acetoneimide] Cu(II) shown below

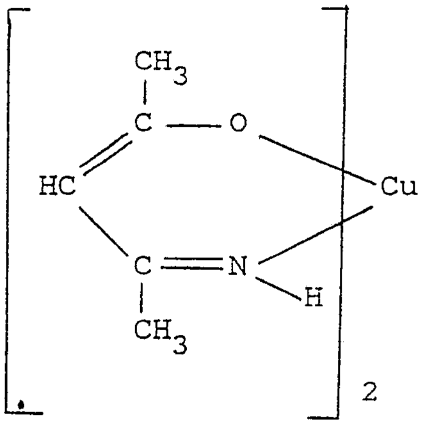

Abbreviation: $Cu(acacimide)_2$

This compound has adequate volatility and has been found to be compatible the Ba and Y chelates, discussed above.

Some details of the volatility and CVD characteristics of the three chelates, alone and in combination, are given below. (It should be noted that the barium and yttrium chelates which were used tend to form hydrates during long exposures to moist air. The attached water molecules are readily driven off, however, by heating at temperatures far below those required for chelate vaporization.)

In order that the invention can be more clearly understood, convenent embodiments thereof will now be described, by way of example, with reference to the accompanying drawings in which:

Figure 1A shows a chemical vapor deposition apparatus for depositing superconducting ceramic films on substrates and Figure 1B shows a longitudinal temperature profile of such a furnace; and

Figure 2 shows Auger profiles from a typical experiment in which the aforementioned chelates were simultaneously vaporized and deposited as a thin film from a typical experiment, with plots being given as relative atomic per cent of copper, yttrium, barium and oxygen, versus sputtering time within the Auger apparatus in minutes (increase in sputtering time corresponds to increased penetration into the film, thus the profiles shown also can be described as plots of composition vs. depth within the deposit).

At vaporization source temperatures of 300 to 350C, with several per cent oxygen in a helium carrier gas, $Ba(hfod)_2$ was used to deposit polycrystalline films of about 1300 A thickness on quartz substrates at 380 to 470C. Similar results were obtained with $Y(hfod)_3$ at a somewhat lower source temperature and with substrate temperatures of 500 to 530C. This established that there is adequate source volatility and control of deposition with substrate temperature for simple oxides to proceed with CVD of the 1:2:3 material.

Figure 1A shows chemical vapor deposition apparatus 10, which utilizes a resistance heated furnace 12 generally around a quartz reaction tube 14. Longitudinal distances from center lines are shown on both sides of the center line and correspond to the temperature profile as a function of longitudinal distance from center line shown in Figure 1B. One or more source boats 16 containing source material 18 provide material for vaporization, which vaporized material is swept downstream by helium carrier gas introduced at helium carrier gas inlet 20 and oxygen containing gas (here an oxygen helium mixture 22) is fed through oxygen feed tube 24 such that it can be mixed adjacent to (i.e. immediately before impinging) heated substrates 26. Auxiliary heating tape 28 was utilized to provide adjustment of the temperature of source boat 16. Gases are exhausted downstream from the substrates 26, through exhaust port 30.

By taking advantage of the fact that $Cu(acacimide)_2$ exhibits volatility similar to that of $Ba(hfod)_2$ and $Y(hfod)_3$, preliminary samples of multicomponent films were prepared using a partitioned source boat containing all three materials at a nominal vaporization source temperature of about 300C. The films were adherent to glass, quartz, and sapphire substrates (single-crystal perovskite substrates are, however, preferred). Film thicknesses ranged to about 15,000 A for deposition temperatures of 300 to 500C.

Auger analyses were made of these films. One example of multiple Auger profiles for a film sample deposited at about 400C is shown in Figure 2. To interpret the main features of the component profiles for the film as it built up on the substrate, read back along the sputtering time scale from 50 minutes toward the origin. From 50 to 30 minutes, the Y and O signals fell slowly by 26 to 29%, while the Ba signal increased by a factor of about 3, appearing to roughly co-vary with the copper signal, which fell by a factor of about 1/2. The form of the Cu profile suggests that the Cu MO source was depleted sooner than the other sources in this experiment, as there were limited amounts of each material and the volatility of the Cu(II) acetyl-acetoneimide was higher. The increasing barium profile toward the center of the deposited film (sputtering time about 20 min) indicates that growth of the multi-component portion of the film was not limited by barium availability.

Key aspects of this invention are the use of chelate source compounds, such as $Ba(hfod)_2$ - Bis[1,1,1,2,2,3,3,-heptafluoro-7,7-dimethyl-4,6-octanedionato] barium(II) and $Y(hfod)_3$ - [1,1,1,2,2,3,3-heptafluoro-7,7-dimethyl 4,6-octanedionato]yttrium(III) both of which have adequate volatility for supplying barium and yttrium in a CVD reactant stream. These two compounds can be used as

source materials at about 300C in a CVD reactor; together with, for example, Cu(acacimide)$_2$. The solid source materials can be held in individual containers and heated at temperatures below 300C to provide, with adjustable flow rates of appropriate inert carrier gases - such as helium, argon, or nitrogen - controlled concentrations of Ba-, Y-, and Cu-containing species in a CVD reactant stream and thus deposit films with selected composition.

Metal chelates constitute a sub-division of metal-organic compounds in which the bonded metal is part of one or more ring structures within the metal-organic molecule. Metal chelates, rather than metal-organic without ring structures, are desirable in the present application because of their enhanced heat stabilities in inert atmospheres, volatilities, and their high resistance to hydrolysis in moist air at room temperature.

Carbon and fluorine are also supplied by the Ba and Y MO source materials and were detected in the films produced initially. It should be noted, however, that the presence of fluorine is not necessarily a detriment since some workers have recently claimed enhanced properties for the 1:2:3 compound when some of the oxygen is replaced by fluorine. However, the presence of fluorine in the deposit can be eliminatedcompletely by substituting bulky Ba and Y chelate which do not contain fluorine. Chelates of this type are known. Examples are:

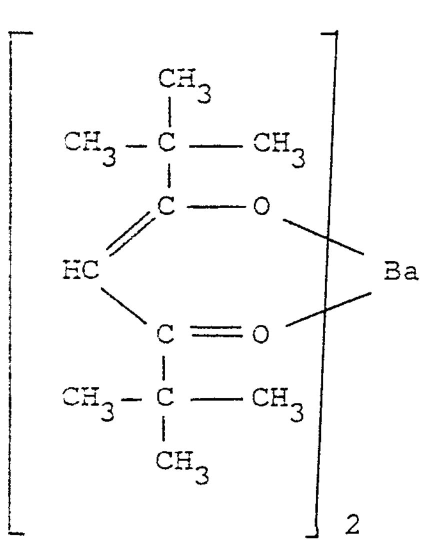

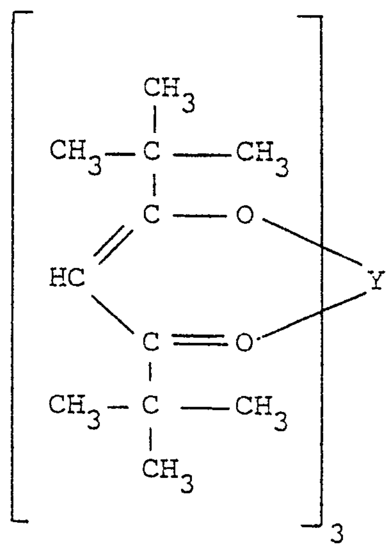

As for essentially eliminating carbon from the deposits, a higher percentage of oxygen in the transport gas stream may well be sufficient to reduce carbon to acceptable levels. It is possible that a mixture of oxygen and water vapor may be even more effective.

There are a number of novel features embodied in the present invention, including the use of a barium chelate which contains a multiplicity of bulky organic groups to confer adequate volatility for CVD work (i.e. the deposition of BaO or $BaCO_3$ on a suitable substrate in the presence of oxygen gas, and the use of a bulky organic chelate of Y for the deposition of $Y_2O_3$ under the same conditions. In addition this is apparently the first use of a volatile β-diketone imide chelate as a source of deposited CuO in the presence of oxygen on a heated substrate (these imide compounds have, however been used to deposit copper metal by CVD in these laboratories, utilizing an atmosphere of hydrogen. U.S. Patent Specification No. 3,594,216 (Charles et al.), July 20, 1971), and the first simultaneous use of the three chelates to simultaneously deposit BaO, $Y_2O_3$, and CuO. By further refinement of the deposition and volatilization experimental technique used here it should be possible to deposit BaO, $Y_2O_3$, and CuO in the proper ratios to form, for example, the superconducting 1:2:3 compound.

In addition, the novel design of equipment should be noted in which the chelates are vaporized from a multicompartmented cell (or three separate cells) and swept downstream with an inert gas to prevent premature decomposition or oxide formation. The metal chelate vapors then encounter a separately introduced stream of oxygen gas adjacent to (i.e. immediately before impinging) a heated quartz substitute.

Generally, as is known in the art, such superconducting ceramics can be post baked in an oxygen atmosphere, generally at temperatures of 400-650C. Again, fluorine can be partially substituted for oxygen in such ceramics and such chelates can be used as at least one of the sources of fluorine.

Generally lower substrate deposition temperatures are preferred and temperatures in the 400-500C range appear to give satisfactory results. A variety of substrates can be used including single-crystal and oriented-crystal to give oriented films. In addition, the ceramic superconductor film can be made directly, using relatively high oxygen in the gaseous chemical vapor deposition mixture and 350-650C substrate temperatures, or indirectly, using either leaner oxygen or lower substrate temperature (e.g. 150-350C) or both.

The indirectly produced ceramic films use heating to greater than 350C to convert the polymer-containing film to an essentially polymer-free crystalline film.

It should be noted that chemical vapor deposition can give extremely homogeneous films (the films of the examples, are, of course, experimental results where the compositions were allowed to vary for convenience in establishing ranges of conditions) as such gaseous mixing provides homogeneity on an atomic level. This homogeneity is very significantly better than that produced by the mixing and milling of dry powders of the constituents, as generally done in the prior art. It should also be noted that while sputtering has been proposed for film deposition, such sputtering has inhomogeneity problems due to source inhomogeneity of the milled, mixed dry powder source material used for sputtering.

Although not shown in Figure 1, it is important that the source materials volatilizations be separately controllable to provide compositional control on the deposited film.

Thus this invention describes chelate-type metal-organic materials which are volatile at 200 to 350C, as sources of Ba and/or Sr, with, for example, Y, and Cu for the chemical vapor deposition of oxide films which upon further heat treatment can yield superconducting oxide (e.g. $YBa_2Cu_3O_7$). Especially in the case of Ba, for the compound $Ba(hfod)_2$, the multiplicity of bulky organic groups overcomes the volatility-supressing influence of the strong Ba-Ba ionic bond. Similar considerations apply for the $Y(hfod)_3$ source material. Used in the simultaneous combination with Cu(II)acetyl-acetoneimide, these sources have yielded oxide films in a CVD reactor provided with a zone of appropriate deposition temperatures.

## Claims

1. A process for producing ceramic superconductor containing barium and/or strontium characterized by: vaporizing chelates of metallic constituents of the superconductor at 150-350C, thereby producing a chelate composite vapor; mixing said chelate composite vapor with oxygen-containing gas to produce a gaseous chemical vapor deposition mixture; heating a substrate to from 350 to 650C; and contacting said gaseous chemical vapor deposition mixture to said substrate to produce a ceramic film.

2. A process according to claim 1, characterized in that the substrate is a single crystal perovskite substrate.

3. A process according to claim 2, characterized in that the substrate is formed from or composed of a single crystal strontium titanate.

4. A process according to claim 1, 2 or 3, characterized in that the metallic constituents consist essentially of yttrium and copper plus and barium and/or strontium.

5. A process according to claim 1, 2, 3 or 4 characterized in that the chelates are vaporized in an inert carrier gas which transports said chelates to a position adjacent to the substrate where said chelates to a mixed with the oxygen-containing gas.

6. A process according to any of claims 1 to 5, characterized in that barium is one of the metallic constituents, and Bis [1,1,1,2,2,3,3,-heptafluoro-7,7- dimethyl-4,6-octanedionato] barium(II) is used as a barium chelate.

7. A process according to any of claims 1 to 6, characterized in that yttrium is one of the metallic constituents, and Tris [1,1,1,2,2,3 3,-heptafluoro-7,7-dimethyl-4,6-octanedionato] yttrium(III) is used as a yttrium chelate.

8. A process according to any of claims 1 to 7, characterized in that copper is one of the metallic constituents, and Bis [acetyl-acetoneimide] copper(II) is used as a copper chelate.

9. A process according to any of claims 1 to 8, characterized in that strontium is one of the metallic constituents, and Bis [1,1,1,2,2,3,3,-heptafluoro-7,7-dimethyl-4,6-octanedionato] strontium(II) is used as a strontium chelate.

10. A process according to any of claims 1 to 8, characterized in that the metallic components consist of yttrium, barium and copper, and fluorine is partially substituted for oxygen in the ceramic.

11. A process according to any of the preceding claims, characterized in that the substrate is heated to from 400 to 500C.

12. A process according to any of the preceding claims, characterized in that the ceramic film is post-baked at 400-650C in an oxygen atmosphere.

13. A process according to claim 1, characterized in that the substrate is an oriented-crystal substrate.

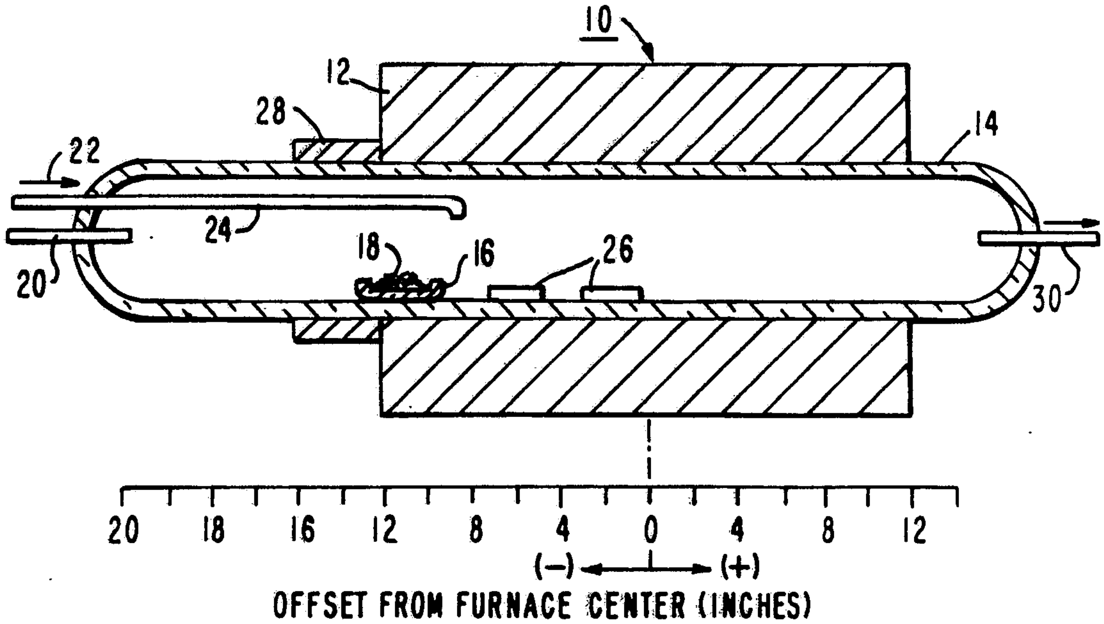
10
12
28
22
14
24
20
18
16
26
30
20
18
16
12
8
4
0
4
8
12
(–)
(+)
OFFSET FROM FURNACE CENTER (INCHES)

FIG.1A

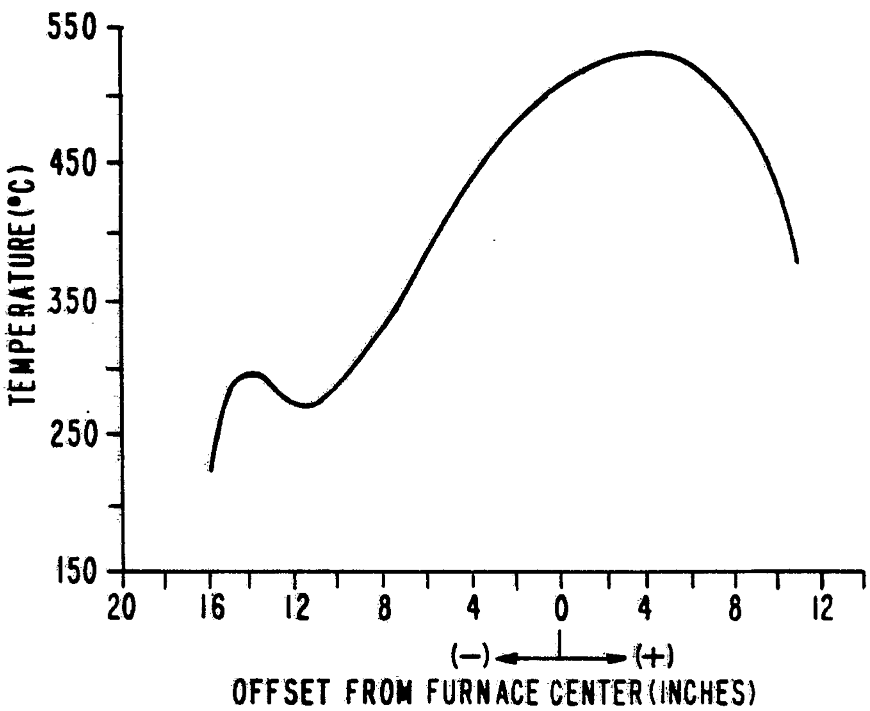
550
450
350
250
150
TEMPERATURE (°C)
20
16
12
8
4
0
4
8
12
(–)
(+)
OFFSET FROM FURNACE CENTER (INCHES)

FIG.1B

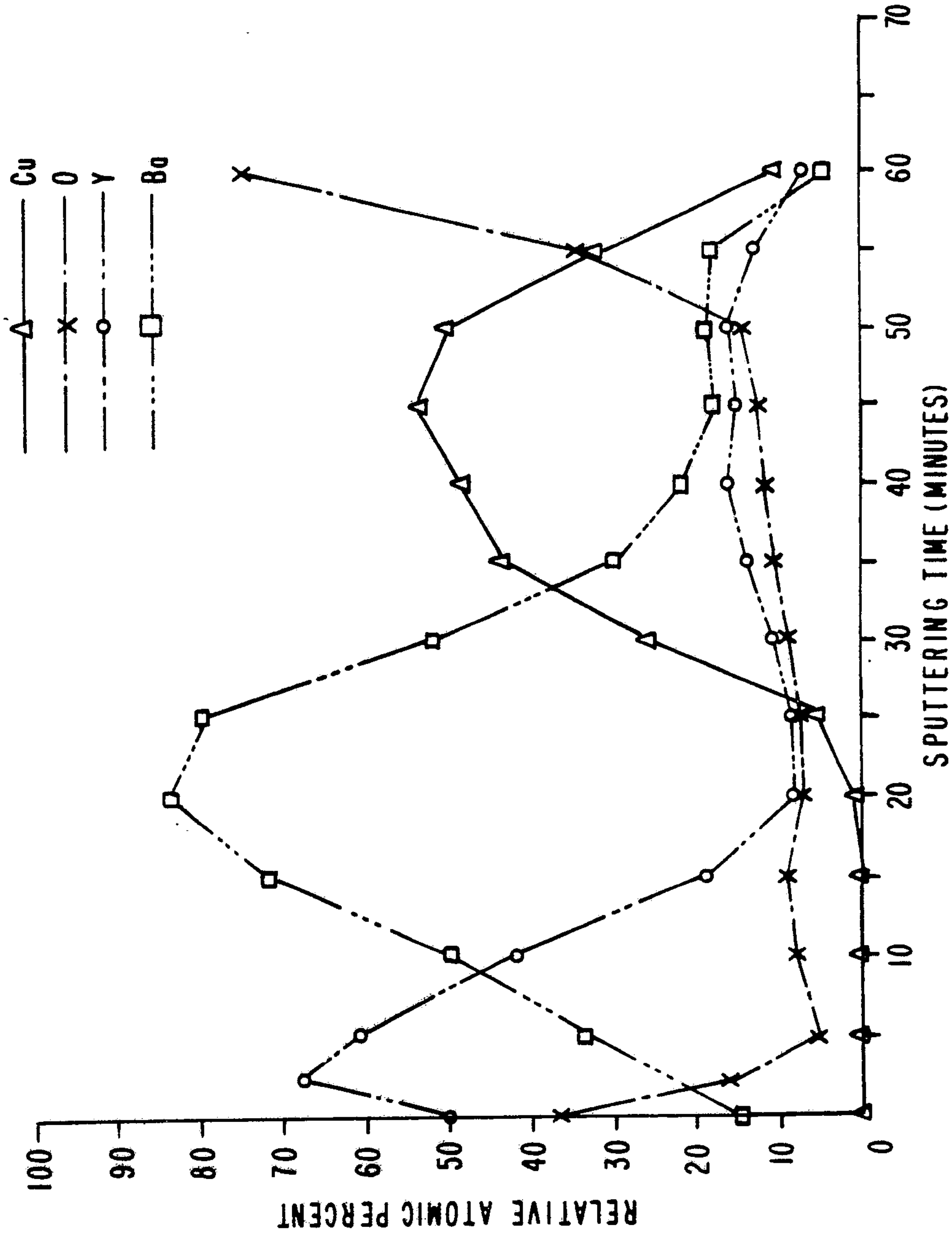
Cu
O
Y
Ba
SPUTTERING TIME (MINUTES)
RELATIVE ATOMIC PERCENT
0
10
20
30
40
50
60
70
80
90
100

FIG.2